# EUROPEAN PATENT SPECIFICATION

(11) **EP 2 882 815 B1**
(45) Date of publication and mention of the grant of the patent: **21.11.2018**
(21) Application number: 13750547.5
(22) Date of filing: 13.08.2013
(51) Int. Cl.: C09D 5/24

(54) **SURFACE COATINGS**
OBERFLÄCHENBESCHICHTUNGEN
REVÊTEMENTS DE SURFACE

(30) Priority: 13.08.2012 GB 201214390; 09.10.2012 GB 201218058; 09.08.2013 GB 201314298
(43) Date of publication of application: 17.06.2015
(73) Proprietor: Europlasma nv, 9700 Oudenaarde (BE)
(72) Inventor: LEGEIN, Filip, B-3140 Keerbergen (BE); MARTENS, Peter, B-9680 Maarkedal (BE); ROGGE, Eva, B-9770 Kruishoutem (BE)
(74) Representative: Connell, Mark
(86) International application number: PCT/EP2013/066879
(87) International publication number: WO 2014/026967

(56) References cited:
- WO-A1-91/12091
- WO-A1-2011/089009
- WO-A2-2006/004969
- WO-A2-2013/034920
- US-A- 5 840 427

## Description

The present invention relates to surface coatings and is especially, although not exclusively, related to corrosion resistant and/or liquid repellent surface coatings which also afford electrical conductivity to an article to which the coating has been applied. The invention also relates to methods of applying surface coatings to articles. Articles are for example the individual components of an electronic (hand held) device.

Electrical circuits are commonly used in components such as printed circuit boards (PCBs), batteries, SIM-cards and so on. These components are put together during a final assembly to form a working device - such as a mobile phone or smartphone - that is ready for use by a customer.

It is known to provide an assembled working device with a surface coating in order to protect the device *per se* against corrosion. For instance, it is known to provide an assembled working mobile phone with a surface coating so that the surface of the mobile phone has water resistant properties.

However, coating assembled devices has significant drawbacks. For instance, protective coatings applied in such a manner do not necessarily protect the surfaces of internal components of the device, particularly the electrical contacts of the internal components. This is because the coating is applied to a device that has already been assembled and therefore not all of the inside surfaces of a device are exposed to the protective coating. Thus, if such a device subsequently comes into contact with water it may be rendered unusable due to moisture penetrating the device and damaging the circuitry.

Several methods have been proposed to address this problem, which methods include the provision of a protective coating over the electrical contacts of a component.

In one method an electrically insulating bonding layer which functions to provide a protective coating is laminated to a component. The electrically insulating bonding layer is laminated to a flat surface of the component at elevated temperature by providing pressure thereon. In a subsequent step vias or holes are drilled through the electrically insulating bonding layer at the positions where an electrical interconnection is required. It is to be appreciated that this is a complex and time consuming multi-step process which requires great accuracy when drilling to ensure that good electrical contact is achieved once the components are assembled.

In another method a thermoplastic insulating matrix which functions to provide a protective coating is applied to a component. The insulating matrix comprises a plurality of conductive nickel fibres. Ideally, the longitudinal axis of each fibre is oriented in a direction perpendicular to the major plane of the component so that once the components are assembled to form a device an electrical contact is made between the components. However, this method is problematic in that each nickel fibre requires an insulating coating to prevent the component itself from shorting. Moreover, the efficacy of such a coating is limited by the degree of accuracy of the fibre orientation. It has been found that it is not always possible to orient all of the fibres in a direction perpendicular to the major plane of the component. Therefore, components having such a coating are often vulnerable to electrical shorting.

In another method an adhesive connecting layer which functions to provide a protective coating is laminated to a component. The adhesive layer enables a second component to be connected thereto. The adhesive layer consists of an insulating, often thermoplastic, resin containing electrically conductive particles arranged such that an electrical contact is made once the components are assembled without the components themselves being vulnerable to electrical shorting. However, due to limitations on the smallest size of the electrically conductive particles available adhesive connecting layers of this type are not suitable for components which are to be included in small devices such as mobile phones.

It is also known to mask the electrical contact points of a component before applying a protective conformal coating to the component. The masking is preferably by means of an adhesive strip. Once the protective coating has been applied to the component the masking is removed so that an electrical contact is made once the components are assembled. It is to be appreciated that the step of masking the electrical contacts requires great accuracy in order to ensure that only the points of contact are rendered free from coating - this is time consuming. Moreover, the step of masking the contact points does not solve the problem of the circuitry becoming damaged when the device is exposed to the elements, *e.g*. water, because there remains a gap (*i.e.* after the masking has been removed) for moisture to penetrate.

As it will be appreciated the prior art coatings and methods of coating require a flat surface so that the coating may be laminated or adhered thereto. Moreover, the surface must be capable of withstanding pressure during the step of lamination or adhesion.

However, the components used by the applicant may be flexible and/or the surfaces thereof may be tightly curved. Further, the components may be delicate and therefore not able to withstand the application of physical pressure.

It is a first non-exclusive object of the invention to provide a surface coating which overcomes, or at least substantially reduces, the disadvantages associated with the known coatings described above.

It is a second non-exclusive object of the invention to provide a surface coating having a substantiallyuniform thickness across at least one surface of an article and/or a surface coating which has better adhesion to an article than that known in the prior art.
It is a further non-exclusive object of the invention to provide an improved method of coating an article with a protective surface coating. Articles are for example the individual components of an electronic (hand held) device.
An even further non-exclusive object of the invention includes a method of treating delicate and/or flexible components.
An even further non-exclusive object of the invention provides a waterproof device of which one or all of the internal components are coated with a protective surface coating.
It is to be understood that by using the term "device", the Inventors mean a completely assembled unit that is ready to use. A device has a (outer) surface that is presented to the user. The outer surface has a decorative value to attract users. A device is built up of one or more "components". In this invention, the Inventors use the term "component" to indicate all electrical parts that are located in the inside of the device. The surfaces of these components are not visible at the outside of the device once the device is fully assembled.

The present invention is defined in claims 1-12 as attached. In a first aspect the invention provides a method of coating a component and/or a device to protect the component and/or the device from corrosion and liquid damage whilst affording electrical conductivity to the coated component and/or the coated device, the method comprising providing on the component and/or the device a layer of a protective polymer species formed from any one or more of the following precursor monomers:
- acrylate;
- methacrylate; or
- organosilane.

Preferably, the method comprises the step of applying the polymer coating across one or more electrical contacts of the component or the components.

Preferably, the method comprises the step of applying the polymer coating to the component or the components such that no area of the component or the components surface is uncoated.

Preferably, the coating is electrically conductive through the thickness of the coating.

Preferably, the coating is electrically insulating across the plane of the coating.

This is advantageous because when components are subsequently assembled, an electrical contact is possible between the contacts of one (*e.g*. coated) component and the contacts of an abutting or adjacent component. There is also little or no risk of the device shorting, *e.g*. from an electrical signal passing from one conductive track on a component to another conductive track on the same component, because the coating is not electrically conductive in the transverse plane.

Preferably, the method comprises the step of protecting at least part of the outer surface of the device from the coating. For instance, the method may comprise the initial step of applying a barrier material, *e.g*. an adhesive tape or film, to at least part of the outer surface of the device to protect the at least part of the outer surface from the coating.

The at least part of the outer surface of the device may be the screen of a mobile phone device, or a tablet computer, or the outer buttons of a music player, *e.g*. the volume buttons of a MP3 player, or the back cover of a mobile phone, or the camera lens of the mobile phone, or any other outer surface of the device that is visible in normal use. In some embodiments substantially the entire outer surface of the device is protected from the coating so that only inner surfaces of the device, which are essentially the (outer) surfaces of the (internal) components, have a coating applied thereto. The advantage being that no unwanted visible or textured traces of the polymer coating are presented to the user.

Preferably, the method comprises the step of depositing the precursor monomer by means of low power and/or low pressure plasma polymerisation.

In some embodiments, the method comprises first the step of a pre-treatment for cleaning and/or etching and/or activating the electronic component or components prior to coating. A pre-treatment in the form of an activation and/or cleaning and/or etching step might be advantageous in improving the adhesion and cross-linking of the polymer coating.

Adhesion of the polymer coating to the electronic component or components is essential for the corrosion resistance of the coated surface. After production of the electronic component, it is often found that some residues from soldering, gluing, handling remain. These residues are mostly organic contamination or contamination in the form of oxides. When the component is coated without a pre-treatment, a substantial part of the polymer coating binds with these residues, which may cause pinholes later on. The pre-treatment in the form of an activation and/or a cleaning and/or an etching removes the contamination and allows improved adhesion of the coating with the surface of the electronic component or components.

Preferably, this pre-treatment is carried out using reactive gases, such as H₂, or O₂, additionally or alternatively with etching reagents such as CF₄, It can also be carried out with inert gases, such as Ar, N₂ or He. Mixtures of the foregoing gases can also be used.

More preferably the pre-treatment is done with O₂, Ar, or a mixture of O₂ and Ar.

Preferably, the pre-treatment is performed from 30 seconds to 30 minutes, for example from 45 seconds to 15 minutes, preferably 1 minute to 10 minutes, e.g. 9, 8, 7, 6, 5, 4, 3, 2, or 1 minutes. The duration of the pre-treatment depends on the precursor used and on the degree of contamination on the part to be treated.

The power used in the pre-treatment can be applied in continuous wave mode or in pulsed wave mode.

Preferably, when applied in continuous wave mode in a 490 litre plasma chamber, the pre-treatment takes place at powers of 5 to 5000 W, more preferably 25 to 4000 W, even more preferably at 50 to 3000 W, say 75 to 2500 W, such as 100 to 2000 W, e.g. 2000, 1900, 1800, 1750, 1700, 1600, 1500, 1400, 1300, 1250, 1200, 1100, 1000, 950, 900, 850, 800, 750, 700, 650, 600, 550, 500, 450, 400, 350, 300, 250, 200, 175, 150, 125, or 100 W.

Preferably, when applied in pulsed wave mode in a 490 litre plasma chamber, the pre-treatment takes place at apower of 5 to 5000 W, more preferably 25 to 4000 W, even more preferably at 50 to 3000 W, say 75 to 2500 W, such as 100 to 2000 W, e.g. 2000, 1900, 1800, 1750, 1700, 1600, 1500, 1400, 1300, 1250, 1200, 1100, 1000, 950, 900, 850, 800, 750, 700, 650, 600, 550, 500, 450, 400, 350, 300, 250, 200, 175, 150, 125, or 100 W.

When applied in pulsed power mode, the pulse frequency may be from 100 Hz to 10 kHz having a duty cycle from approximately 0.05 to 50 %, with the optimum parameters being dependent on the gas or gas mixture used.

Preferably, in a 490 litre plasma chamber, the operating pressure for the pre-treatment is 10 to 500 mTorr, more preferably 15 to 250 mTorr, even more preferably 20 to 200 mTorr, say 25 to 175 mTorr, such as 30 to 150 mTorr, e.g. 150, 140, 130, 125, 120, 110, 100, 95, 90, 85, 80, 75, 70, 65, 60, 55, 50, 45, 40, 35, or 30 mTorr.

For systems of other dimensions, with another volume and/or electrode set-up, the power value, the operating pressure and the pre-treatment time are varied in a way that the best process parameters for the pre-treatment are used.

A 490 litre plasma chamber can accommodate a number of components, for example, 200 smartphones, or 200 mobile phones, or 100 tablet computers, or 70 keyboards in one single batch. Such a chamber can be used for both pre-treatment and polymer coating treatment of components or devices.

In the embodiments where no pre-treatment is performed, the coating step is the first and only step of the whole process. When a pre-treatment is used, the protective polymer coating is applied as a next step, which can be carried out in the same chamber..

Clearly it is advantageous for a number of reasons to perform the pre-treatment and the coating treatment in the same chamber: this is more efficient from a handling point of view, and will be quicker and cheaper than using multiple chambers.

Preferably, the pre-treatment and the coating step are carried out in the same chamber without opening the chamber in between the steps, to avoid or at least minimise the risk of deposition of contaminants or additional contamination from the atmosphere on the electronic component or components in between pre-treatment step and coating step.

lin a 490 litre plasma chamber, , the operating pressure for the coating step is approximately 10 to 500 mTorr, preferably approximately 15 to 200 mTorr, more preferably approximately 20 to 150 mTorr, say 30 to 100 mTorr, say less than 100, 90, 80, 70, 60, 50, 40, 30 mTorr, such as 50 mTorr.

The method may apply the low power and/or low pressure plasma polymerisation in continuous wave (CW) or in pulsed power mode.

Preferably, the method involves a polymerisation time of approximately 30 seconds to approximately 30 minutes. The longer the polymerisation time the thicker the resultant polymer coating. Therefore, the choice of polymerisation time and hence coating thickness depends to a certain degree on the use or application of the component being coated.

Preferably, the method involves a polymerisation time of approximately 1 minute to approximately 25 minutes, *e.g.* approximately 3 minutes to approximately 25 minutes, *e.g.* approximately 3 minutes to approximately 20 minutes, *e.g*. approximately 5 minutes to approximately 20 minutes, *e.g.* approximately 7 minutes to approximately 20 minutes, *e.g.* approximately 10 minutes to approximately 20 minutes, *e.g*. approximately 10 minutes to approximately 18 minutes, *e.g.* approximately 10 minutes to approximately 16 minutes, *e.g.* approximately 12 minutes to approximately 16 minutes, such as approximately 13, 14 or 15 minutes.

Preferably, the method comprises the steps of:
- providing the protective polymer species to at least one component (*e.g*. SIM-card, battery, microphone, connectors or mobile phone handset); and
- assembling the component with one or more further components to form the working device.

The method may also comprise the step of initially disassembling the working device.

The method may also comprise the step of conducting a pre-treatment to clean and/or activate and/or etch one or more surfaces of the component or components prior to coating deposition.

In a second aspect the invention provides a component and/or a device having a polymer coating thereon for protecting the component and/or the device from corrosion whilst affording electrical conductivity to the coated component and/or the coated device, the coating being formed from any one or more of the following precursor monomers:
- acrylate;
- methacrylate; or
- organosilane.

The device may be an electronic (hand held) device such as a mobile phone; a smart phone; a personal digital assistant (PDA); a tablet computer; a loudspeaker; a music player such as an MP3 player; an e-reader; a keyboard; a GPS system; a device used for sport such as a pedometer, heart rate monitor, cadence sensor and the like; a video camera; or a photo camera.

The device is built up from one or more components, such as a printed circuit board (PCB), a battery, a SIM-card, a connector, and so on.

Preferably, the component or the components comprises polymer coating across one or more electrical contacts thereof.

Preferably, the component or the components comprises no uncoated surface .

Alternatively, at least a part of the outer surface of the device may be uncoated, *e.g*. substantially the entire outer surface of the device may be uncoated. By substantially the entire outer surface we mean the surfaces of the device visible to a user, e.g. the camera lens, the back cover, the (touch)screen, the outside buttons.

Preferably, the coating is a result of the or each precursor monomer being polymerised and deposited by means of low power and/or low pressure plasma polymerisation.

Preferably, the acrylate and/or methacrylate precursor monomers comprise a perfluorocarbon chain.

Preferably, the acrylate and/or methacrylate precursor monomers have a generic formula (I):

CₙF₂ₙ₊₁Cₘ X₂ₘCR₁Y-OCO-C(R₂)=CH₂ (I)

wherein n is 2 to 9, m is 1 to 9, X and Y is H, F, CI, Br or I and R₁ is -H or an alkyl, *e.g*. -CH₃, or a substituted alkyl, *e.g.* an at least partially halo-substituted alkyl, R₂ is H or an alkyl, *e.g. -* CH₃, or a substituted alkyl, *e.g*. an at least partially halo substituted alkyl.

In some embodiments R₁ may be H, R₂ may be H and Y may be H.

In some embodiments n is 2 to 6, m is 0 to 9, X and Y is H, F, CI, Br or I and R₁ is H or an alkyl, *e.g.* -CH₃, or a substituted alkyl, *e.g.* an at least partially halo-substituted alkyl, R₂ is H or an alkyl, *e.g.* -CH₃, or a substituted alkyl, *e.g.* an at least partially halo substituted alkyl. In such embodiments the inventors have discovered that the polymer coating has a superhydrophobic surface with contact angles for water of more than 100 degrees. The same coatings are superoleophobic with oil repellency levels above 4, for example up to 6 according to ISO14419. Such superhydrophobic and/or superoleophobic surfaces formed from this particular class of monomer are found to be free of perfluorooctanoic acid (PFOA) or perfluorooctane sulfonate (PFOS), in contrast to the superhydrophobic and/or superoleophobic surfaces formed from embodiments with n from 7 to 9, e.g. 8, n being the number of carbon atoms of the perfluorocarbon chain of the molecule. By free we mean that the degree of PFOA and PFOS is below the detectable limit.

Surprisingly, the Inventors have found that having one or all components and the inside of the device coated with superhydrophobic and/or superoleophobic surfaces formed from monomers having the general formula (I) may make electronic devices such as electronic hand held devices splash-proof and/or waterproof by blocking the water ingress into the (re)assembled device upon accidental exposure to water, even without coating the outside of the device.

And even in those cases where water is forced to enter the electronic (hand held) device, any damge to the latter will be minimised if not obviated entirely because of the separately coated key electronic component or components. The protective coating on the inside of the electronic (hand held) device protects the device against short circuiting due to water ingress.

Superhydrophobic and/or superoleophobic surfaces formed from monomers having the general formula (I) may make electronic (hand held) devices splash-proof and/or waterproof. The coated devices reach IPX 6 to IPX 7, depending on the composition of the (re)assembled electronic (hand held) device itself and on the precursor monomer used.

In some industries, particularly the production of wire and cables, there has been a shift away from use of perfluorocarbons because in some but not all circumstances toxic by-products may be formed. The Inventors have surprisingly found that by use of organosilane precursor monomers no toxic by-products are formed.

Preferably, the organosilane precursor monomers comprise siloxanes, silanes or mixtures thereof.

Preferably, the organosilane precursor monomers have a generic formula (II), or are cyclic monomers comprising the repeating unit (III).

Monomers comprising formula (II) are of the structure

Y₁-X-Y₂ (II)

wherein X is O or NH, Y₁ is 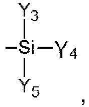 Y₂ is 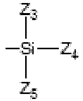 and wherein Y₃, Y₄, Y₅, Z₃, Z₄, and Z₅ are each independently H or an alkyl group. The alkyl groups may be linear or branched. The alkyl groups are a C₁ to C₁₀-alkyl, preferably C₁ to C₅-alkyl, more preferably C₁ to C₂-alkyl, for example -CH₃.

In some embodiments Y₁ and Y₂ are the same, and so Y₃ will be the same as Z₃, Y₄ the same as Z₄ and Y₅ the same as Z₅.

Preferably neither silicon atom in Y₁ and/or Y₂ is bound to three H-atoms, so that preferably at least one of Y₃, Y₄, or Y₅, and at least one of Z₃, Z₄ and Z₅ are each independently H or an alkyl group. In some embodiments, any or each of Y₃ and Z₃, Y₄ and Z₄, Y₅ and Z₅ may be identical.

Preferably, the organosilane precursor monomer is hexamethyldisiloxane (HMDSO) or hexamethyldisilazane (HMDS).

Possible cyclic monomers are monomers comprising n times the repeating unit (III) 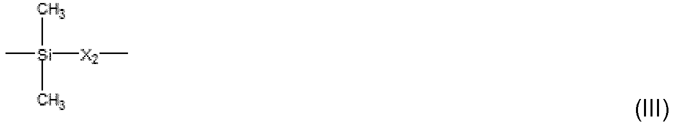 wherein X₂ is O or NH, and wherein n is 2 to 10, preferably 3 to 6, for example 6, 5, 4, or 3.

Preferably, the method comprises the step of introducing the or each organosilane precursor monomer to a chamber, *e.g*. a plasma chamber, by means of a carrier gas such as H₂, N₂, O₂, N₂O, CH₄, He or Ar, most preferably O₂.

The composition of gas introduced to the chamber preferably comprises about 1 % to about 50 % carrier gas. Preferably, the composition of gas introduced to the chamber comprises about 5 % to about 30 % carrier gas, and more preferably about 10 % carrier gas.

Preferably, the coating has a thickness in the range of about 10 nm to about 1 µm, preferably about 10 nm to about 500 nm, or more preferably about 20 nm to about 250 nm, or yet more preferably about 30 nm to about 150 nm, or most preferably about 40 nm to about 100 nm, such as about 70 nm. It is to be understood that the thickness of the coating will vary depending on the substrate, the choice of precursor monomer, the deposition conditions (e.g. temperature, pressure, flow rate) and process time etc.

The Inventors have also found that, contrary to prior art teachings, those coatings using acrylates or methacrylate precursor monomers do not require a carrier gas because these types of monomer are able to strike the plasma themselves in order to initiate polymerisation.

Preferably, the coating is applied in a single step - in other words deposited in an uninterrupted single process. The thickness of the deposited single polymer layer is in the range from approximately 10 nm to 500 nm, usually approximately 100 nm, although this depends on the monomer precursors used and also the treatment time.

As used herein the terms "x-axis" and "y-axis" shall refer to axes extending in a plane forming or comprising a surface of the component.

As used herein the term "z-axis" shall refer to an axis perpendicular to the major surface of the component. Thus, an electrical contact through the coating between one component and an adjacent component may be termed z-axis conductivity.

In order that the invention may be more readily understood, it will now be described by way of example only and with reference to the accompanying drawings, in which:
Figure 1 shows a schematic illustration of a needle having a coating in accordance with the invention;
Figure 2 shows a schematic illustration of an assembled device (a) and a disassembled device (b);
Figure 3 shows a schematic illustration of an electronic component coated with a coating according to the invention; and
Figure 4 shows a schematic illustration of a plasma system suitable to perform the method of the present invention.

The Inventors have discovered that any one or more of the following precursor monomers may be utilised to form a corrosion resistant and/or liquid repellent surface coating which also affords electrical conductivity to a component to which the coating has been applied.

The precursor monomers may be selected from the following families:
- acrylates;
- methacrylates;
- organosilanes; or mixtures thereof.

More specifically, the inventors have found that precursor monomers having the formula (I)

CₙF₂ₙ₊₁Cₘ X₂ₘCR₁Y-OCO-C(R₂)= CH₂ (I)

form coatings having particularly good corrosion resistance whilst affording electrical conductivity to the component to which they are applied.

In formula (I) n is 2 to 9, m is 1 to 9, X and Y is H, F, CI, Br or I and R₁ is H or an alkyl, *e.g*. - CH₃, or a substituted alkyl, *e.g*. an at least partially halo-substituted alkyl, R₂ is H or an alkyl, *e.g.* -CH₃, or a substituted alkyl, *e.g.* an at least partially halo substituted alkyl.
In one embodiment n is 8, m is 1, X is H, R₁ is H, Y is H and R₂ is H, *i.e.* 1H,1H,2H,2H-perfluorodecyl acrylate.
In a second embodiment n is 8, m is 1, X is H, R₁ is H, Y is H, and R₂ is -CH₃, *i.e.* 1H, 1H,2H,2H-perfluorodecyl methacrylate.

In a third embodiment n is 6, m is 1, X is H, R₁ is H, Y is H, and R₂ is H, *i.e.* 1H,1H,2H,2H-perfluorooctyl acrylate.
In a fourth embodiment n is 6, m is 1, X is H, R₁ is H, Y is H, and R₂ is -CH₃, *i.e.* 1H, 1H,2H,2H-perfluorooctyl methacrylate.

The Inventors have found that organosilane precursor monomers, such as one or more of siloxanes or silanes also form coatings having particularly good corrosion resistance whilst affording electrical conductivity to the component to which they are applied. Organosilanes have been found to produce no toxic by-products when deposited by low power plasma deposition.

The organosilane precursor monomers may be represented by general formula (II), or are cyclic monomers comprising the repeating unit (III).:

Y₁ -X-Y₂ (II)

wherein X is O or NH, Y₁ is 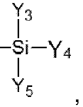 Y₂ is 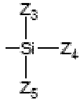 and wherein Y₃, Y₄ and Y₅, Z₃, Z₄, and Z₅ are each independently H or an alkyl group. The alkyl groups may be linear or branched. The alkyl groups are a C₁ to C₁₀-alkyl, preferably C₁ to C₅-alkyl, more preferably C₁ to C₂-alkyl, for example -CH₃.

Preferably neither silicon atom in Y₁ and/or Y₂ is bound to three H-atoms, so that preferably at least one of Y₃, Y₄, or Y₅, and at least one of Z₃, Z₄ and Z₅ are each independently H or an alkyl group. In some embodiments, any or each of Y₃ and Z₃, Y₄ and Z₄, Y₅ and Z₅ may be identical.

In a first embodiment, X is O, Y₁ is identical to Y₂, and Y₃, Y₄, Y₅, Z₃, Z₄ and Z₅ are -CH₃, e.g. hexamethyldisiloxane (HMDSO).

In a second embodiment X is NH, Y₁ is identical to Y₂, and Y₃, Y₄, Y₅, Z₃, Z₄ and Z₅ are -CH₃, indicating the monomer hexamethyldisilazane (HMDSN).

In a third embodiment X is O, Y₃, Y₄, Y₅, Z₃ and Z₄ are -CH₃ and Z₅ is H, indicating the monomer pentamethyldisiloxane.

In a fourth embodiment X is O, Y₁ is identical to Y₂, and Y₃, Y₄, Y₅, Z₃, Z₄ and Z₅ are -CH₃, indicating the monomer hexaethyldisiloxane.

Possible cyclic monomers are monomers comprising n times the repeating unit (III) 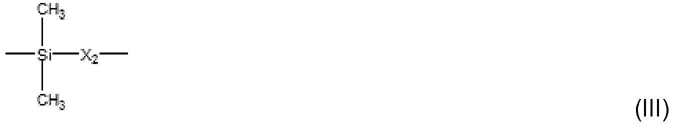 wherein X₂ is O or NH, and wherein n is 2 to 10, preferably 3 to 6, for example 6, 5, 4, or 3.

In another embodiment X₂ is O and n is 4, indicating the monomer octamethylcyclotetrasiloxane.

In yet another embodiment X₂ is O and n is 5, indicating the monomer decamethylcyclopentasiloxane.

In yet another embodiment X₂ is O and n is 6, indicating the monomer dodecylmethylcyclohexasiloxane.

In yet another embodiment X₂ is NH and n is 3, indicating the monomer hexamethylcyclotrisilazane.

In a yet further embodiment X₂ is NH and n is 4, indicating the monomer octamethylcyclotetrasilazane.

In some embodiments a pre-treatment step to clean and/or activate and/or etch one or each component of a working device is performed prior to the coating deposition step is preferred.

Preferably, this pre-treatment is done using reactive gases, *e.g*. H₂, O₂, etching reagents such as CF₄, or inert gases, such as Ar, N₂ or He. Mixtures of the foregoing gases can also be used.

More P preferably the pre-treatment is done with O₂, Ar, or a mixture of O₂ and Ar.

In those cases where a pre-treatment is performed to clean and/or activate and/or etch the surface of the individual components, this step is done after evacuation of the chamber and before introduction of one or more different precursor monomers. Suitable reagents for performing this pre-treatment process are for example O₂, Ar, or a mixture of O₂ and Ar.

During the pre-treatment, the power can be applied in continuous wave mode or in pulsed wave mode.

When applied in pulsed power mode, the pulse frequency may be from 100 Hz to 10 kHz having a duty cycle from approximately 0.05 to 50 %, with the optimum parameters being dependent on the gas or gas mixture used and configuration of the chamber and the plasma used.

The Applicants have found that in a 490 litre plasma chamber, for satisfactory results the operating pressure for the pre-treatment can range from 10 to 500 mTorr, but that good results are obtained in the range 30 to 150 mTorr.

The pre-treatment can be performed over a period ranging from 30 seconds to 30 minutes, but more typically over periods from 1 minute to 10 minutes. Factors affecting the duration of the pre-treatment include the precursor used, the degree of contamination on the individual components to be treated, the size of the chamber, the power used and pattern or shape of the plasma.

The protective coating of the present invention is typically applied to the components of a working device such as a mobile phone, a smartphone or a hearing aid as follows.

During the manufacture of a working device, the individual components of the device are placed into a plasma chamber such that their surfaces, including the electrical contact points, will be exposed to a precursor monomer in the presence of a plasma. The chamber is evacuated to a low pressure and the monomer precursor is introduced into the chamber. The plasma is then struck. The plasma initiates polymerisation such that the components are therefore coated with a protective polymer coating (the deposition process will be discussed in further detail below). In this embodiment it is to be appreciated that the individual components are treated prior to their assembly into the final working device.

Alternatively, in those cases where a part or the complete outer surface of the device is already manufactured, at least part of this outer surface is covered with a barrier material, *e.g*. an adhesive tape or film.

Alternatively, if possible, the part or the complete outer surface of the device that is already manufactured, is not placed in the plasma chamber and no coating is applied.

Alternatively, a fully assembled working device, such as a mobile phone, a smartphone, a keyboard or a hearing aid, may be disassembled into its individual components so that the components can be treated at a component level. The individually coated components are subsequently reassembled to form a working device having a protective coating thereon.

Alternatively, the method comprises the step of protecting at least part of the outer surface of the device from the coating. For instance, the method may comprise the initial step of applying a barrier material, e.g. an adhesive tape or film, to at least part of the outer surface of the device to protect the at least part of the outer surface from the coating.

Once the device has been assembled or reassembled as described above, the device may have a further coating applied thereto by placing the device as a whole, into a plasma chamber and repeating the deposition process. It may be preferable that the device may be partially covered with a barrier material to prevent deposition of the polymer on parts of the device suchas a screen or camera lens,

The plasma deposition process is carried out as follows. Once the individual components or the device *per se* have been introduced to the plasma chamber, the chamber is evacuated and one or more different precursor monomers are introduced. These monomers are normally introduced in gaseous form. An RF electromagnetic field is turned on and a plasma struck. During short treatment times, typically around 2 to 15 minutes, a plasma will cause a substantially uniform protective polymer coating to be deposited onto the components. The coating covers all surfaces of the component that have been exposed to the plasma, including any electrical contact points. The RF electromagnetic field is then turned off, which will extinguish the plasma and the plasma chamber is brought back to atmospheric pressure.

The power used for the coating step can be applied in continuous wave mode or in pulsed wave mode. It is known from prior art that for complex precursors, especially acrylates and methacrylates of the present invention, the average applied power at which the plasma coating process takes place has to be low to keep the functional group of precursor molecule intact,
The average power at which the coating process will take place depends strongly on the precursor monomer used and on the size and design of the chamber and layout of the electrodes. The choice of manner in which the power is applied will depend upon the required average power for the given system and the pre-cursor monomer or monomers used. For example, in a small chamber of 50 litres volume, a low average power will normally be required However, it may not be possible to meet the low power requirements with a continuous power mode of plasma, so a pulsed plasma mode is used instead.

Preferably, in a 490 litre plasma chamber, the applied power for the coating process, when applied in continuous wave mode, is in the range from 5 to 5000 W, more preferably approximately 10 to 2500 W, even more preferably approximately, say 15 to 2000W, for example 20 to 1500 W, say 25 to 1000 W, say 30 to 750 W, say 35 to 500 W, say 500, 475, 450, 425, 400, 375, 350, 325, 300, 275, 250, 225, 200, 190, 180, 175, 170, 160, 150, 140, 130, 125, 120, 110, 100, 95, 90, 85, 80, 75, 70, 65, 60,55, 50, 45, 40, or 35 W.

Preferably, in a 490 litre plasma chamber, the applied power for the coating process, when applied in pulsed wave mode, is approximately 5 to 5000 W, more preferably approximately 10 to 4000 W, even more preferably approximately, say 20 to 3000W, for example 30 to 2500 W, say 50 to 2000 W, say 75 to 1500 W, say 100 to 1000 W, say 1000, 975, 950, 925, 900, 875, 850, 825, 800, 775, 750, 725, 700, 675, 650, 625, 600, 575, 550, 525, 500, 475, 450, 425, 400, 375, 350, 325, 300, 275, 250, 225, 200, 190, 180, 175, 170, 160, 150, 140, 130, 125, 120, 110, or 100 W.

Preferably, when in pulsed power mode, the pulse repetition frequency may be from 100 Hz to 10 kHz having a duty cycle from approximately 0.05 to 50 %, with the optimum parameters being dependent on the monomer used.

Preferably, the radiofrequency electrode or electrodes generate a high frequency electric field at frequencies of from 20 kHz to 2.45 GHz, more preferably of from 40 kHz to 13.56 MHz, with 13.56 MHz being preferred.

In some embodiments, the plasma chamber has at least two inlets for the precursor monomer or the pre-treatment reagents.

Preferably, during the pre-treatment step, each inlet feeds the pre-treatment gas or gas mixture into a distribution system that distributes the gas or gas mixture evenly across the chamber. For example, the inlet may feed into a manifold which feeds the chamber.

Preferably, during the coating step, each inlet feeds monomer, preferably combined with a carrier gas for organosilane precursor monomers, into a monomer distribution system that distributes the monomer, preferably combined with a carrier gas for organosilane precursor monomers, evenly across the chamber. For example, the monomer inlet may feed into a manifold which feeds the chamber.

In one embodiment, each inlet is spatially distinct. For instance, a first inlet may be provided in a first wall of the plasma chamber and a second inlet may be provided in a different wall to the first inlet, e.g. the opposite wall.

In some embodiments, the method may comprise introducing the pre-treatment gas or gas mixture and/or the monomer, preferably combined with a carrier gas for organosilane precursor monomers, into the plasma chamber in a first flow direction; and switching the flow after a predetermined time, for example from 10 to 200 seconds, for example from 30 to 180, 40 to 150 seconds, for example less than 150, 140, 130, 120, 110, 100, 90, 80, 70, 60, 50, 40, 30 or 20 seconds to a second flow direction.

Preferably, further switching of the flow direction may be executed, *e*.*g.* the flow may be switched back to the first flow direction or to one or more further flow directions.

Preferably, the monomer and/or carrier gas/gases mixture may enter the plasma chamber in the first flow direction for between 20 to 80 % of a single process time or 30 to 70 % of the time or 40 to 60 % of the time or 50 % of the time.

Preferably, the monomer and/or carrier gas/gases mixture may enter the plasma chamber in the second flow direction for between 20 to 80 % of a single process time or 30 to 70 % of the time or 40 to 60 % of the time or 50 % of the time.

Preferably, the first and second flow directions flow in substantially opposite directions. For instance, during a process, pre-treatment gas or gas mixture and/or monomer, preferably combined with a carrier gas for organosilane precursor monomers, may be introduced into the plasma chamber via walls which are substantially opposite to each another.

In another embodiment, the first and second flow directions may flow in direction oriented at a tangential angle to each other. In case of two flow directions, the flow is on one direction and then switched preferably in the reverse direction.

An advantage of switching the flow direction during the process is that a more uniform monomer distribution and corresponding pressure distribution is created inside the plasma chamber. In larger chambers, *e.g*. chambers of 200 litres and more, this allows a more uniform pre-treatment (which is a cleaning and/or activation and/or etching process), and more uniform coating thicknesses on the electronic components to be coated, throughout the plasma chamber. Smaller chambers of for example 50 litres are generally small enough to allow uniform plasma distribution throughout the chamber from a single chamber inlet, although in some cases cross-flow may have a benefit in these chambers as well.

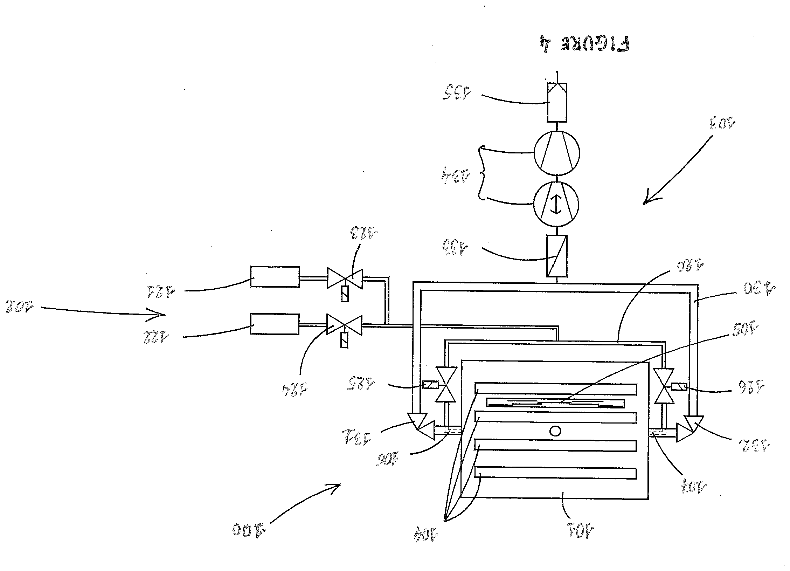

With reference to Figure 4, a plasma deposition system that may be used for the present invention will now be described. The system, indicated generally at 100, includes a vacuum chamber 101 in communication with input apparatus 102 via an input line 120 and an exhaust apparatus 103 via an output line 130. The input apparatus 102 includes a liquid monomer supply system 121, a gas supply system 122 and first 125 and second 126 chamber inlet valves. In the embodiments where a pre-treatment is performed using a gas mixture, additional gas supply systems may be used. The exhaust apparatus 103 includes in flow order first 131 and second 132 pump valves, a throttle valve 133, a roots and rotary pump 134 and an exhaust valve 135.

Within the vacuum chamber 101 there are electrodes 104 arranged in stacked formation. Interposed between each plasma electrode set 104 is a sample tray 105. For purpose of clarity only a single sample tray 105 is shown in Figure 4, the sample tray 105 being interposed between the lower pair of electrodes 104. The space between adjacent electrode sets 104 is a sample chamber. In use, one or more electronic components are located on or within the sample tray 105. The sample tray 105 is subsequently positioned between a pair of electrodes 104 within the vacuum chamber 101.

For the ease of the description, the process sequence that is described below only includes a coating step, using a monomer that does not require a carrier gas. In some embodiments a pre-treatment cleaning and/or activation and/or etching process is performed prior to coating deposition. In those cases where the precursor monomer is an organosilane monomer, a carrier gas is preferably used to strike the plasma.

Once the sample tray 105 is located within the vacuum chamber 101, the chamber 101 is evacuated and the pressure is reduced to a base level vacuum by means of the pump 134 with the first 131 and second 132 pump valves open and the first 125 and second 126 chamber inlets valves closed. A quantity of monomer is vaporized in the liquid monomer supply system 127.

In alternative embodiments, solid or gaseous monomer may be used. In embodiments where the monomer is a solid then it may also vaporised, e.g. by heating in a canister. In embodiments where the monomer is a gas then there is typically no need for vaporisation.

Once the target lower pressure within the vacuum chamber 101 is reached, the first pump valve 131 is closed, and the first chamber inlet valve 125 and the liquid monomer supply valve 138 are opened. Controlled amounts of precursor monomer vapour flow into the chamber 101. The pressure within the chamber 101 is regulated at an operating level, which depends on the equipment and the monomer used, by either introduction of more monomer or regulation of the throttle valve 133, which is typically a butterfly valve.

Once the pressure within the chamber 101 is stable, the electrode sets 104 are activated to generate plasma within the chamber 101. Thus, the monomer is activated and polymerisation occurs on one or more surfaces of the electronic component or components on sample trays 105.

During the process, the direction of monomer flow through the chamber 101 may be switched by control of the first 125 and second 126 chamber inlet valves and first 131 and second 132 pump valves. For example, for half the time the first chamber inlet valve 125 is open and the first pump valve 131 is closed (with the second chamber inlet valve 126 closed and second pump valve 132 open). For the remainder of the time, the second chamber inlet valve 126 is open and second pump valve 132 closed (with the first chamber inlet valve 125 closed and the first pump valve 131 open). This means that for half the time monomer flows from one side of the chamber 101 to another and for the remainder of the time vice versa. For example, for half the time monomer flows from the right to the left and for the remainder of the time monomer flows from the left to the right. The direction of monomer flow may be alternated one or more times during a single process run.

The inlet 120 and outlet 130 lines are separate from each other. The inlet line 120 may be coupled to a distribution system arranged to distribute gas across the chamber 101. The distribution system may be integrated on or within the wall of the chamber 101 so that it can be maintained at the same temperature as the chamber 101.

At the end of either process it is recommended for operator safety that the chamber inlet valves 125, 126 are closed and the chamber 101 pressure is reduced to base level to remove any residual monomer present. An inert gas such as nitrogen is introduced from a third canister 122 by opening valve 124. The nitrogen is used as a purge fluid and is pumped away with the residual monomer. After completion of the purge, the vacuum is removed and air is introduced into the chamber 101 until atmospheric pressure is achieved.

The precursor monomers of the present invention may be either gaseous or liquid. Liquid precursors are evaporated by heating before being introduced into the plasma chamber. Gaseous precursors are introduced into the plasma chamber as such.

Where the precursor monomer or monomers are organosilanes, the or each monomer is preferably introduced into the plasma chamber in combination with a carrier gas, such as H₂, N₂, O₂, N₂O, CH₄, He or Ar. The carrier gas also functions to initiate the polymerisation by striking the plasma.

In one embodiment the carrier gas was O₂ and the total gas flow contained 15 % carrier gas and 85 % monomer.

In another embodiment the carrier gas was O₂ and the total gas flow contained 10 % carrier gas and 90 % monomer.

Where the precursor monomer or monomers are acrylates or methacrylates there is no need for a carrier gas because these types of monomer are able to strike the plasma in order to initiate polymerisation themselves.

The coating comprises a single thin polymer layer having a thickness in the range of approximately 20 nm to 200 nm, usually approximately 100 nm, although this depends on the monomer precursors used and also the treatment time.

Once the components have been assembled into a device, the coatings are such that an electrical contact is made through the coating and between two components. In other words the coating is said to be z-axis conductive. Moreover, the risk of the device shorting is very low or close to zero because the coating is electrically insulating in a plane which is orthogonal to the z- axis and in a transverse plane, in other words the x-axis direction and the y-axis direction.

In order to prove the inventive concept the following examples are provided for demonstration purposes only.

### Example 1

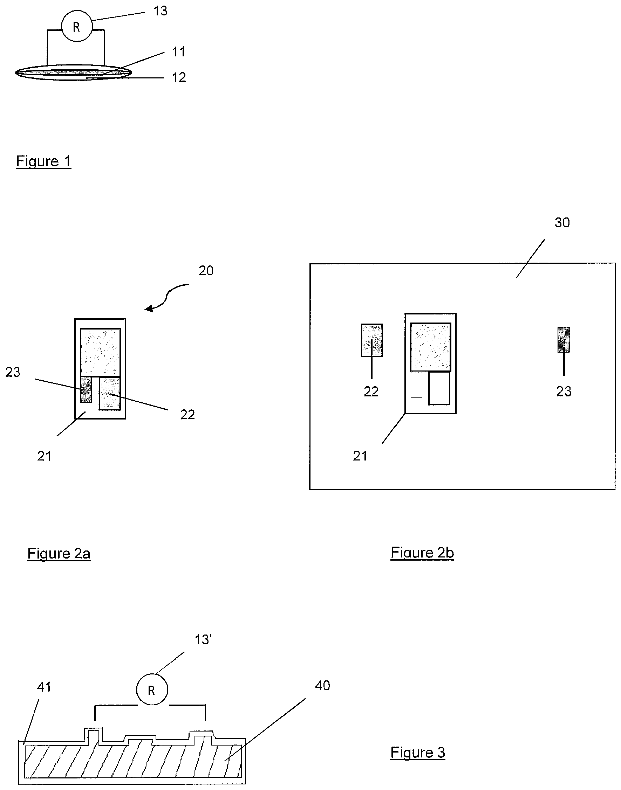

Referring first to Figure 1 a needle 11 formed from an electrically conductive material was coated by means of depositing a polymer coating 12 by low power plasma deposition. The precursor monomer utilised was 1H,1H,2H,2H-perfluorodecyl acrylate.

Conductivity through the coating was measured every 5 minutes during the polymerisation treatment by means of a resistance measurement meter 13. The data are shown in Table 1.

**Table 1: Electrical conductivity as a function of treatment time and coating thickness**

| **Treatment time** | **Coating thickness** | **Electrically conductive through coating** |
|---|---|---|
| 5 minutes | 65 nm | Yes |
| 10 minutes | 125 nm | Yes |
| 15 minutes | 185 nm | Yes |
| 20 minutes | 250 nm | Yes |
| 30 minutes | 375 nm | Yes |
| 40 minutes | 500 nm | Yes |

As will be appreciated, the results show that the coating remained conductive in the z-axis even after long treatments of 40 minutes where the polymer coating has a thickness of 500 nm.

### Example 2

Small electrical components of a microphone for a hearing aid device were coated with protective coatings in accordance with Table 2. In process 1 the precursor monomer was 1H,1H,2H,2H-perfluorodecyl acrylate; in process 2 the precursor monomer used was 1H,1H,2H,2H-perfluorooctyl methacrylate; and in process 3 the precursor monomer used was hexamethyldisiloxane (HMDSO). The components were assembled and the hearing aid device was switched on. It was found that the hearing aid device operated which demonstrates that each coating was electrically conductive through its thickness (as will be appreciated from Table 3).

**Table 2: Overview of process 1 to 3 when coating applied to electronic parts of a microphone for a hearing aid device**

| | **Process** 1 | **Process** 2 | **Process** 3 |
|---|---|---|---|
| **Precursor Monomer** | C₁₃H₇O₂F₁₇ | C₁₂H₉O₂F₁₃ | HMDSO |
| **Oil repellency (ISO 14419)** | Level 8 | Level 5-6 | Level 0 |
| **Electrode** | RF/Ground | RF/Ground | RF/Ground |
| **Frequency** | 13,56 MHz | 13,56 MHz | 13,56 MHz |
| **Frequency mode** | pulsed | cw | cw |
| **Treatment time** | 2 minutes | 5 minutes | 5 minutes |

**Table 3: Shows the thickness of each coating of process 1 to 3 and demonstrates that the coatings are electrically conductive through their thickness**

| **Process** | **Coating thickness** | **Electrically conductive through coating** |
|---|---|---|
| Process 1 | 50 nm | Yes |
| Process 2 | 150 nm | Yes |
| Process 3 | 300 nm | Yes |

### Example 3

Figure 2a shows an assembled mobile phone 20 comprising a handset 21, a battery 22 and a SIM-card 23. Each of the handset 21, battery 22 and SIM-card 23 have electrical contacts.

After disassembly of the phone 20, the handset 21, battery 22 and SIM-card 23 were placed in a plasma chamber 30 as shown in Figure 2b. The components were pre-treated with O₂ for 2 to 5 minutes and coated with a protective coating according to the invention by means of low power plasma deposition for approximately 10 to 20 minutes.

The handset 21, battery 22 and SIM-card 23 were subsequently reassembled to form the usable mobile phone 20. Power to the mobile phone 20 was turned on and the device worked.

The mobile phone 20 was then placed underwater for approximately 10 minutes. When the mobile phone 20 was removed from the water and turned on again it functioned.

The mobile phone 20 was also subjected to a complex salt-spray corrosion test and it was found that the functionality thereof was unaffected even after 6 consecutive test cycles. Furthermore, no corrosion was visible.

The complex salt-spray corrosion test cycle consisted of 3 steps:
- Spraying of a 5 % salt-water solution onto the sample for 30 minutes
- Storing the sample at high moisture for 120 minutes
- Storing the sample at room temperature for 60 minutes.

The same salt-spray test was performed on a mobile phone, the components of which had not been subjected to a protective coating according to the invention. Clear signs of corrosion were visible.

### Example 4

Electronic components for loud speakers were coated according to the 3 processes in Table 4. Two different monomers were used. After coating the electronic components are tested with a corrosion test according to IEC 60068-2-52. Afterwards, no corrosion was visible for the components pre-treated with Ar and O₂, and a few small corrosion spots were visible on some but not all of the samples coated without pre-treatment. Uncoated reference samples showed heavy corrosion after the corrosion test.

**Table 4: Overview of process 1 to 3 when coating applied to electronic parts of a loud speaker**

| | **Process 1** | **Process 2** | **Process 3** |
|---|---|---|---|
| **Pre-treatment** | / | Ar | O₂ |
| **Pre-treatment time** | / | 5 minutes | 5 minutes |
| **Precursor Monomer** | C₁₃H₇O₂F₁₇ | C₁₃H₇O₂F₁₇ | HMDSO |
| **Frequency** | 13,56 MHz | 13,56 MHz | 13,56 MHz |

| **Frequency mode** | Cw | cw | cw |
|---|---|---|---|
| **Coating time** | 20 minutes | 20 minutes | 15 minutes |
| **Corrosion after test** | Almost nothing | None | None |

### Example 5

Figure 3 shows an electronic component 40 of an MP3 player which has been coated according to one aspect of the invention with a protective coating 41 by means of low power plasma deposition for approximately 10 minutes. A resistance measurement through the coating 41 by means of a resistance measurement meter 13' indicated electrical conductivity through the thickness of the coating 41. Afterwards, the component 40 was assembled into a working MP3 player.

### Example 6

The following experiment was carried out to demonstrate that the coating is able to withstand repeated weathering and testing.

A copper plate was coated with a protective polymer layer in accordance with the invention. The coated copper plate was then subjected to the salt-spray corrosion test as described in Example 3, following which no corrosion was observed. Electrical conductivity through the coating was measured and it was confirmed that the coated copper plate was z-axis conductive.

This cycle was repeated a second and a third time. No corrosion was observed following each cycle and the coating remained electrically conductive through its thickness.

The fact that no corrosion was observed also confirms that no damage is inflicted on the coating by repeated measurements using the resistance measurement device.

**Table 5: Shows that no corrosion was observed and the coating remained z-axis conductive following repeated exposure to a corrosion test**

| **Test cycle** | **Corrosion** | **Electrically conductive through coating** |
|---|---|---|
| 1 cycle | No | Yes |
| 2 cycles | No | Yes |
| 3 cycles | No | Yes |

### Example 7: Oil and water repellence

Applicant discovered that the choice of mode in which the power is applied (either pulsed wave mode or continuous wave mode) depends on the monomer and the equipment used. This is especially the case for the acrylates and methacrylates used in the present invention. The Applicant has found that perfluoro(meth)acrylates containing maximum 6 carbon atoms in the perfluorocarbon chain result in polymer coatings having significantly better oil repellency levels when deposited in continuous wave mode, rather than in pulsed wave mode. In continuous wave mode oil repellence level 6 according to ISO 14419 is obtained at low power, *e.g.* at 100 W, and in short treatment times, *e.g.* 2 minutes in a plasma chamber of 490 I - in which *e.g*. 200 smartphones or 100 tablet computers are coated in one single batch. It is disadvantageous to use high power, *e.g*. 350 W, 500 W, 1000 W or even more because the monomer precursor may fragment, leading to poor coatings which tend to have low levels of uniformity of quality and thickness.

**Table 6: Shows the oil repellency levels for continuous wave and pulsed wave processes**

| **Deposition mode** | **Treatment time (min)** | **Oil repellency** |
|---|---|---|
| Continuous wave (cw) | 2 minutes | L 6 |
| Pulsed | 2 minutes | L 3 |
| Continuous wave (cw) | 5 minutes | L 6 |
| Pulsed | 5 minutes | L 4 |

### Example 8: Water ingress and submersion

A mobile phone, such as a smartphone, *e.g*. an iPhone 4, an iPhone 4S or a Samsung Galaxy II, was coated with a protective polymer coating as follows:
- The mobile phone was disassembled by removing the back cover;
- The microphone, camera, SIM-card and battery were removed from the mobile phone;
- The camera lens and the outer surface of the mobile phone were protected with a protective film;
- A plasma pre-treatment was performed to clean, activate and etch the exposed surfaces of the mobile phone;
- Low power continuous wave plasma polymerisation was used to deposit a polymer coating to the exposed surfaces of the mobile phone;
- The protective film was then removed from the camera lens and the outer surface of the mobile phone;
- The mobile phone was then re-assembled, resulting in a mobile phone having a polymer coating applied to the inside surfaces thereof.

### Test 1

The mobile phone was sprayed with water for 5 minutes on the front, the back, the left and the right side. During spraying, the mobile phone was tilted by an angle of 45°. Afterwards, the mobile phone was tested and no functional defects were observed.

### Test 2

The mobile phone was dropped from a height of 50 cm into a container of water. The mobile phone was left totally submerged for 1 minute. Afterwards, the mobile phone was tested and no functional defects were observed.

### Test 3

An iPhone 4, iPhone 4S and Samsung Galaxy II were coated with a protective polymer coating as described above. Water was then projected at a flow rate of 100 I/min at a pressure of 100 kN/m² from all angles onto the phones for a period of 3 minutes. Afterwards, the moisture sensors had not changed colour and no functional defects were observed.

### Test 4

The iPhone 4, iPhone 4S and Samsung Galaxy II of Test 3 were also submerged in water for 2 minutes. No water ingress was observed after the 2 minutes. The mobile phones were tested and no functional defects were observed.

### Test 5

To force water ingress, coated hand held devices (iPhone 4 and iPhone 4S) according to the above method were submerged in water for 2 minutes. Water was forced to enter the device via the opening of the charger by dropping the device vertically into the water. After 2 minutes, the hand held devices were taken out of the water and water was allowed to drip out. The devices were tested and no functional defects were observed. The back cover was removed for a control check and the moisture sensors had not changed colour.

### Test 6

An iPhone 4, iPhone 4S and Samsung Galaxy II were coated according to the above method and then submerged in water for 30 minutes. Afterwards, the back cover was removed for a control check and the moisture sensors had not changed colour. All functions were tested and no functional defects were found. No water ingress was observed.

The coating of the invention can be applied to all exposed surfaces of a component before the component has been assembled into the final device. Further, the subsequently assembled device operates even though the coating has been applied across the electrical contacts of the individual components. The method of deposition requires no additional steps, such as the masking of contact points or the drilling of vias and therefore provides a quick and simple, yet cost effective, solution to providing a device with a corrosion resistant protective coating. The method also avoids the need to apply physical pressure to a component in order to laminate a coating thereto. Thus, the inventive coatings can be applied on flexible and delicate components. As will be appreciated, the inventive coatings protect the circuitry from corrosion and/or liquid damage whilst at the same time enable an electrical contact to be made.

Finally, the embodiments of the invention which utilise organosilane monomers may be preferred because such monomers do not produce toxic by-products when deposited by low power plasma deposition. Thus, organosilane monomers may be considered to be a non-toxic alternative.

## Claims

1. A component having a polymer coating thereon protecting the component from corrosion and providing electrical conductivity to electrical contacts on the component, the coating being formed from any one or more of the precursor monomers comprising acrylate, methacrylate or organosilanes and in which the component is coated across substantially the entire surface, including one or more electrical contacts thereof and the polymer coating is electrically conductive in a direction extending through a thickness of the coating and is substantially electrically insulating in a direction extending parallel to the surface of the polymer coating.

2. The component of Claim 1, wherein the component is one of a printed circuit board (PCB), a battery, a SIM-card, a connector, or a camera.

3. The component of either of Claims 1 or 2, wherein the / or each acrylate and/or each methacrylate precursor monomer include a perfluorocarbon chain.

4. The component of any one of Claims 1 to 3, wherein the / or each acrylate and/or the or each methacrylate precursor monomers have a generic formula (I):
CₙF₂ₙ₊₁CₘX₂ₘCR₁Y-OCO-C(R₂)=CH₂ (I)
wherein n is 2 to 9, m is 1 to 9, X and Y is H, F, CI, Br or I and R₁ is -H or an alkyl, e.g. -CH₃, or a substituted alkyl, e.g. an at least partially halo-substituted alkyl, R₂ is H or an alkyl, e g. - CH₃, or a substituted alkyl, e.g. an at least partially halo substituted alkyl.

5. The component of any one of Claims 1 to 4, wherein the component reaches an oil repellence level from 4 to and including 7.

6. The component of either of Claims 1 or 2, wherein the organosilane precursor monomers have a generic formula (II):
Y₁-X- Y₂ (II)
wherein X is O or NH, Y₁ is 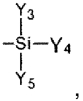 Y₂ is 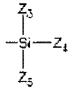 and wherein Y₃, Y₄, Y₅, Z₃, Z₄ and Z₅ are each independently H or an alkyl.

7. The component of Claim 6, wherein the alkyl groups are C₁ to C₅-alkyl.

8. The component of any either of Claims 1 or 2, wherein the organosilane precursor monomers are cyclic monomers having n times the repeating unit (III): 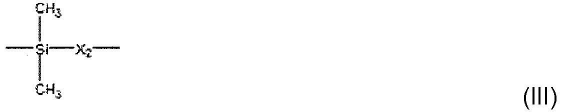 wherein X₂ is O or NH, and wherein n is 2 to 10.

9. The component of Claim 8, wherein n is 3 to 6.

10. The component of any one of Claims 1 to 9, wherein the polymer coating comprises a single layer.

11. The component of any one of Claims 1 to 10, wherein the coating has a thickness from about 10 nm to about 1 µm.

12. An electronic device including at least one component according to any one of Claims 1 to 11, the device including any one or more of a smartphone. a mobile phone, a personal digital assistant (PDA), a loudspeaker, a tablet computer, a music player such as a MP3 player, an e-reader, a keyboard, a GPS system, a pedometer, a heart rate monitor, a cadence sensor, a video camera, or a photo camera.

## Patentansprüche

1. Komponente mit einer Polymerbeschichtung darauf, wodurch die Komponente vor Korrosion geschützt und elektrischen Kontakten an der Komponente elektrische Leitfähigkeit verliehen wird, wobei die Beschichtung aus einem beliebigen oder mehreren der Vorläufermonomere umfassend Acrylat, Methacrylat oder Organosilane gebildet wird und wobei die Komponente über im Wesentlichen die gesamte Oberfläche einschließlich eines oder mehrerer elektrischer Kontakte davon beschichtet wird und die Polymerbeschichtung elektrisch leitfähig in einer Richtung ist, die sich durch eine Dicke der Beschichtung erstreckt, und im Wesentlichen elektrisch isolierend in einer Richtung ist, die sich parallel zu der Oberfläche der Polymerbeschichtung erstreckt.

2. Komponente nach Anspruch 1, wobei die Komponente eine(r) einer gedruckten Leiterplatte (PCB), einer Batterie, einer SIM-Karte, eines Verbinders oder einer Kamera ist.

3. Komponente nach Anspruch 1 oder 2, wobei das oder jedes Acrylat- und/oder jedes Methacrylat-Vorläufermonomer eine Perfluorkohlenstoffkette beinhaltet.

4. Komponente nach einem der Ansprüche 1 bis 3, wobei das oder jedes Acrylat- und/oder das oder jedes Methacrylat-Vorläufermonomer eine generische Formel (I) aufweisen:
CₙF₂ₙ₊₁CₘX₂ₘCR₁Y-OCO-C(R₂)=CH₂ (I)
wobei gilt: n ist 2 bis 9, m ist 1 bis 9, X und Y ist H, F, Cl, Br oder I und R₁ ist -H oder ein Alkyl, z. B. -CH₃, oder ein substituiertes Alkyl, z. B. ein mindestens teilweise halosubstituiertes Alkyl, R₂ ist H oder ein Alkyl, z.B.-CH₃, oder ein substituiertes Alkyl, z. B. ein mindestens teilweise halosubstituiertes Alkyl.

5. Komponente nach einem der Ansprüche 1 bis 4, wobei die Komponente einen Ölabstoßungsgrad von 4 bis und einschließlich 7 erreicht.

6. Komponente nach Anspruch 1 oder 2, wobei die Organosilan-Vorläufermonomere eine generische Formel (II) aufweisen:
Y₁-X-Y₂ (II)
wobei gilt: X ist O oder NH, Y₁ ist 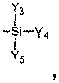 Y₂ ist 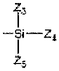 und wobei Y₃, Y₄, Y₅, Z₃, Z₄ und Z₅ jeweils unabhängig H oder ein Alkyl sind.

7. Komponente nach Anspruch 6, wobei die Alkylgruppen C₁- bis C₅-Alkyl sind.

8. Komponente nach Anspruch 1 oder 2, wobei die Organosilan-Vorläufermonomere zyklische Monomere sind, die n-mal die Wiederholungseinheit (III) aufweisen: 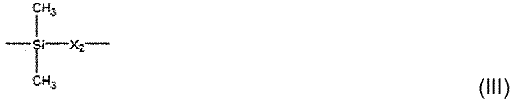 wobei gilt: X₂ ist O oder NH, und wobei n 2 bis 10 ist.

9. Komponente nach Anspruch 8, wobei n 3 bis 6 ist.

10. Komponente nach einem der Ansprüche 1 bis 9, wobei die Polymerbeschichtung eine einzelne Schicht umfasst.

11. Komponente nach einem der Ansprüche 1 bis 10, wobei die Beschichtung eine Dicke von 20 etwa 10 nm bis etwa 1 µm aufweist.

12. Elektronische Vorrichtung mit mindestens einer Komponente nach einem der Ansprüche 1 bis 11, wobei die Vorrichtung ein beliebiges oder mehrere eines Smartphones, eines Handys, eines PDA (Personal Digital Assistant), eines Lautsprechers, eines Tablet-Computers, eines Musikspielers wie z. B. eines MP3-Spielers, eines E-Lesers, einer Tastatur, eines GPS-Systems, eines Pedometers, eines Herzfrequenzmonitors, eines Kadenzsensors, einer Videokamera oder einer Fotokamera beinhaltet.

## Revendications

1. Un composant ayant un revêtement polymère, protégeant le composant contre la corrosion et fournissant une conductivité électrique à des contacts électriques sur le composant, le revêtement étant formé d'un ou plusieurs monomères précurseurs comprenant un acrylate, un méthacrylate ou des organosilanes et dans lequel le composant est revêtu sensiblement sur la totalité de la surface, incluant un ou plusieurs contacts électriques de celui-ci et le revêtement polymère est électriquement conducteur dans une direction s'étendant à travers une épaisseur du revêtement et est sensiblement isolant électriquement dans une direction s'étendant parallèlement à la surface du revêtement polymère.

2. Le composant selon la revendication 1, dans lequel le composant est soit une carte à circuit imprimé (PCB), une batterie, une carte SIM, un connecteur ou une caméra.

3. Le composant selon l'une quelconque des revendications 1 ou 2, dans lequel le / ou chaque monomère précurseur acrylate et / ou chaque monomère précurseur méthacrylate inclut une chaîne de perfluorocarbone.

4. Le composant selon l'une quelconque des revendications 1 à 3, dans lequel le / ou chaque monomère précurseur acrylate et / ou le / ou chaque monomère précurseur méthacrylate a une formule générique (I):
CₙF₂ₙ₊₁CₘX₂ₘCR₁Y-OCO-C(R₂)=CH₂ (I)
dans lequel n est 2 à 9, m est 1 à 9, X et Y est H, F, Cl, Br ou I et R₁ est -H ou un alkyle, par ex. -CH₃, ou un alkyle substitué, par ex. un alkyle au moins partiellement substitué par un halogène, R₂ est H ou un alkyle, par ex. -CH₃, ou un alkyle substitué, par ex. un alkyle au moins partiellement substitué par un halogène.

5. Le composant selon l'une quelconque des revendications 1 à 4, dans lequel le composant atteint un niveau oléofuge compris entre 4 et 7.

6. Le composant selon l'une quelconque des revendications 1 ou 2, dans lequel les monomères précurseurs organosilanes ont une formule générique (II):
Y₁-X-Y₂ (II)
dans lequel X est O ou NH, Y₁ est 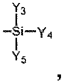 Y₂ est 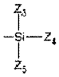 et dans lequel Y₃, Y₄, Y₅, Z₃, Z₄ et Z₅ sont chacun indépendamment H ou un alkyle.

7. Le composant selon la revendication 6, dans lequel les groupes alkyle sont un alkyle en C₁ à C₅.

8. Le composant selon l'une quelconque des revendications 1 ou 2, dans lequel les monomères précurseurs organosilanes sont des monomères cycliques ayant n fois l'unité de répétition (III): 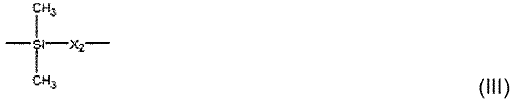 dans lequel X₂ est O ou NH, et dans lequel n est 2 à 10.

9. Le composant selon la revendication 8, dans lequel n est 3 à 6.

10. Le composant selon l'une quelconque des revendications 1 à 9, dans lequel le revêtement polymère comprend une seule couche.

11. Le composant selon l'une quelconque des revendications 1 à 10, dans lequel le revêtement a une épaisseur comprise entre environ 10 nm et environ 1 µm.

12. Un dispositif électronique incluant un ou plusieurs composants selon l'une quelconque des revendications 1 à 11, le dispositif incluant soit un smartphone, un téléphone mobile, un assistant numérique personnel (PDA), un haut-parleur, un ordinateur tablette, un lecteur de musique tel un lecteur MP3, un lecteur électronique, un clavier, un système GPS, un pédomètre, un moniteur de fréquence cardiaque, un capteur de cadence, une caméra vidéo ou une appareil photo.
